(19) Europäisches Patentamt
European Patent Office
Office européen des brevets

(11) **EP 4 407 659 A1**

(12) **EUROPEAN PATENT APPLICATION**
published in accordance with Art. 153(4) EPC

(43) Date of publication:
**31.07.2024 Bulletin 2024/31**

(21) Application number: **22883392.7**

(22) Date of filing: **07.10.2022**

(51) International Patent Classification (IPC):
*H01L 21/304* (2006.01)    *B32B 27/00* (2006.01)
*C09J 7/20* (2018.01)    *C09J 7/29* (2018.01)
*C09J 7/38* (2018.01)    *C09J 201/00* (2006.01)
*H01L 21/301* (2006.01)    *H01L 21/683* (2006.01)

(52) Cooperative Patent Classification (CPC):
**B32B 27/00; C09J 7/20; C09J 7/29; C09J 7/38;
C09J 201/00; H01L 21/30; H01L 21/304;
H01L 21/683**

(86) International application number:
**PCT/JP2022/037680**

(87) International publication number:
**WO 2023/068088 (27.04.2023 Gazette 2023/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.10.2021 JP 2021171657**

(71) Applicant: **Denka Company Limited
Tokyo 103-8338 (JP)**

(72) Inventors:
• **HASUMI, Mizuki
  Tokyo 103-8338 (JP)**
• **MOTOIKE, Shingo
  Tokyo 103-8338 (JP)**
• **IIZUKA, Kazuki
  Tokyo 103-8338 (JP)**
• **NAKAMURA, Masashi
  Tokyo 103-8338 (JP)**

(74) Representative: **Gulde & Partner
Patent- und Rechtsanwaltskanzlei mbB
Wallstraße 58/59
10179 Berlin (DE)**

(54) **BASE MATERIAL WHICH IS USED FOR ADHESIVE SHEET FOR PROCESSING SEMICONDUCTOR WAFER HAVING PROJECTED PART**

(57)     The present invention provides a base material for semiconductor wafer processing, the base material being capable of enhancing adhesion to a stage in a semiconductor wafer processing step. The present invention provides a base material which is used for an adhesive sheet for processing a semiconductor wafer having a projected part, wherein the thermal shrinkages of the base material in the machine direction (MD) and in the transverse direction (TD) after heating at 130°C for 10 minutes are both 0% or more.

FIG.1

**Description**

[TECHNICAL FIELD]

This invention relates to a base material used for adhesive sheets for processing semiconductor wafers, which are used for grinding and cutting the backside of the semiconductor wafers.

[BACKGROUND ART]

When processing semiconductor wafers, adhesive sheets are applied to protect them from damage. For example, during back grinding process when processing the semiconductor wafers, the adhesive sheet is attached to protect a pattern surface of the semiconductor wafer. Adhesive sheets are required to have adhesion to pattern surfaces with unevenness such as protruding electrodes (bumps) and an ability to follow the unevenness of the pattern surfaces (step-following property), from the standpoint of reliability in protecting the pattern surfaces.

Patent Document 1 discloses that the base material film as the adhesive tape is made of a base material film with excellent heat resistance to prevent stage adsorption failure even when applied to high-vacuum and high-temperature processes.

[RELATED ART DOCUMENT]

[PATENT DOCUMENT]

Patent Document 1: JP2020-155688A

[DISCLOSURE OF THE INVENTION]

[PROBLEMS TO BE SOLVED BY THE INVENTION]

When the inventors made a diligent study of the adhesive sheet disclosed in Patent Document 1, they found that the base material may not fully adhere to a stage due to the occurrence of sagging in the base material. Upon detailed investigation, it became clear that the conventional base material including the base material film disclosed in Patent Document 1 stretches unevenly in machine direction (MD) and/or transverse direction (TD) of the base material when heated, resulting in the occurrence of sagging in the base material.

The present invention was made in view of these circumstances, and provides a base material for processing a semiconductor wafer, which can improve the adhesion of the base material to the stage in the step of processing the semiconductor wafer.

[MEANS OF SOLVING THE PROBLEMS]

The inventors have studied the above problems and found that the problems can be solved when each thermal shrinkage of the base material in MD and TD after heating at 130°C for 10 minutes is 0% or higher, and thus the invention has been completed.

According to the present invention, it is provided a base material used for an adhesive sheet for processing a semiconductor wafer having projected portions, in which each thermal shrinkage of the base material in MD and TD after heating at 130°C for 10 minutes is 0% or higher.

Various embodiments of the invention are illustrated below. The embodiments shown below can be combined with each other.

Preferably, a ratio of the thermal shrinkages of the base material in MD and TD (MD/TD) after heating at 130°C for 10 minutes is 3.5 or less.

Preferably, each thermal shrinkage of the base material in MD and TD after heating at 130°C for 10 minutes is 1.0% or less.

Preferably, the base material has a support layer and a cushion layer.

Preferably, the cushion layer has a melting point of 70°C or higher.

According to the present invention, it is also provided an adhesive sheet for processing a semiconductor wafer having projected portions, the adhesive sheet including the base material and an adhesive layer provided on the base material, in which the adhesive sheet is configured so that the projected portions are protected by the base material when the semiconductor wafer is attached to the adhesive layer.

Preferably, the support layer is provided on the opposite side of the adhesive layer as viewed from the cushion layer.

Preferably, the projected portions are protected by being embedded in the base material.

Preferably, the semiconductor wafer is attached to the adhesive layer.

According to the present invention, it is also provided a method for manufacturing semiconductor devices using the adhesive sheet,

in which the method includes a frame attaching step, a wafer attaching step, a heating step, a grinding step, and a dicing step,
in the frame attaching step, the adhesive sheet is attached to a ring frame,
in the wafer attaching step, the adhesive sheet is attached to a surface with the projected portions of the semiconductor wafer,
in the heating step, the base material is heated,
in the grinding step, a back surface of the semiconductor wafer is ground, and
in the dicing step, the semiconductor wafer is diced into individual pieces.

Preferably, the dicing step further includes a fixing step, in which in the fixing step, the semiconductor wafer is fixed to a table via the adhesive sheet.

[EFFECTS OF THE INVENTION]

According to the present invention, it is possible to provide an adhesive sheet for processing a semiconductor wafer that does not cause sagging in the base material during heating and attaching with the ring frame and semiconductor wafer, and that has improved adhesion to a stage set in equipment during dicing and backgrinding.

[BRIEF DESCRIPTION OF THE DRAWINGS]

FIG. 1 shows a cross-sectional view of an adhesive sheet 10 equipped with a base material 1 according to an embodiment of the present invention;
FIGs. 2A to 2D show cross-sectional views showing each step of a method for manufacturing a semiconductor device using the adhesive sheet 10 of the embodiment of the present invention;
FIGs. 3A and 3B show cross-sectional views showing each step of the method for manufacturing the semiconductor device using the adhesive sheet 10 of the embodiment of the present invention; and
FIGs. 4A to 4E show cross-sectional views showing each step of the method for manufacturing the semiconductor device using the adhesive sheet 10 of the embodiment of the present invention.

[MODE FOR CARRYING OUT THE INVENTION]

Embodiments of the invention are described below. The various features shown in the following embodiments can be combined with each other. In addition, each of the features can be independently inventive.

1. Adhesive sheet

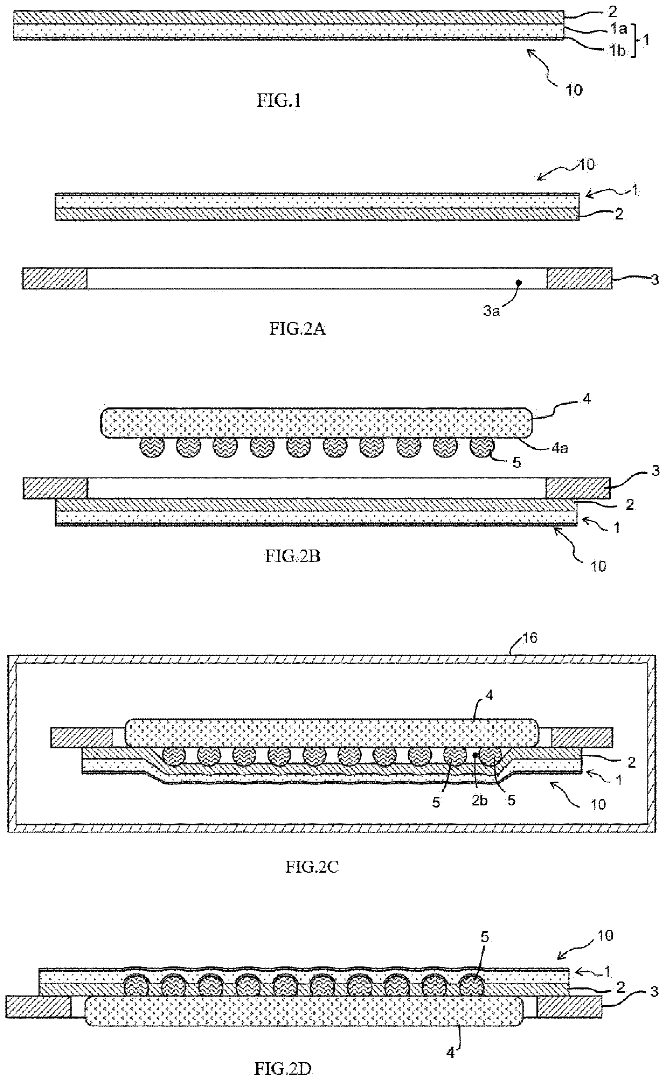

Figs. 1 to 4E describe a base material 1 and an adhesive sheet 10 of an embodiment of the present invention. The adhesive sheet 10 of this embodiment has the base material 1 and an adhesive layer 2 provided on the base material 1. The adhesive sheet 10 is used for grinding a back surface 4b of a semiconductor wafer 4 having projected portions 5 and for dicing the semiconductor wafer 4. Each configuration is described below.

<Base Material 1>

The base material 1 may have an oxygen permeability of 1000 ml/(m$^2$·24h·atm) or less as measured according to JIS K 7126-2 (isobaric method) at 25°C and under RH 0%. In the base material 1, each thermal shrinkage of the base material 1 in MD and TD after heating at 130°C for 10 minutes may be 0% or higher, and it is preferable that the thermal shrinkage after heating at 80 to 150°C for 10 minutes is 0% or higher, for example.

Each thermal shrinkage is calculated from the respective formulae below by measuring the MD and TD lengths of the base material 1 with 100 mm on each side after placing it in an oven at 130°C for 10 minutes and then under atmosphere at 23°C for 2 hours.

MD thermal shrinkage = [(100 mm - length of MD after heating) / 100 mm] * 100

$$\text{TD thermal shrinkage} = [(100 \text{ mm} - \text{length of TD after heating}) / 100 \text{ mm}] * 100$$

By using such the base material 1 in which MD and TD thermal shrinkages after heating at 130°C for 10 minutes are 0% or higher, sagging of the base material 1 can be suppressed during heating and attaching with a ring frame and a semiconductor wafer. This allows for improved adhesion to a stage set in the equipment for back grinding and dicing processes, resulting in contributing to yield improvement. If the thermal shrinkage of MD or TD is less than 0%, sagging occurs in the base material 1 during heating and attaching with the ring frame and semiconductor wafer, resulting in poor adhesion to the stage set in the equipment for the back grinding and dicing processes.

The ratio of thermal shrinkages of the base material 1 in MD and TD (MD/TD) after heating at 130°C for 10 minutes may be 0 to 3.5 (e.g., 3.5, 3.4, 3.3, 3.2, 3.1, 3.0, 2.9, 2.8, 2.7, 2.6, 2.5, 2.4, 2.3, 2.2, 2.1, 2.0, 1.9, 1.8, 1.7, 1.6, 1.5, 1.4, 1.3, 1.2, 1.1, 1.0, 0.9, 0.8, 0.7, 0.6, 0.5, 0.4, 0.3, 0.2, 0.1, 0.05 and 0.01 or less). When the ratio of thermal shrinkage is 0 to 3.5, the adhesion is improved.

Each thermal shrinkage of the base material 1 in MD and TD after heating at 130° C for 10 minutes may be 1.0% or less (e.g., 1.0, 0.9, 0.8, 0.7, 0.6, 0.5, 0.4, 0.3, 0.2, 0.1, 0.05, and 0.01). If each of MD thermal shrinkage and TD thermal shrinkage is 1.0% or less, the ring frame and semiconductor wafer are not subjected to too much shrinkage stress during heating and attaching with the ring frame and semiconductor wafer, thereby reducing peeling from the ring frame, and cracking and chipping of the semiconductor wafer during back grinding and dicing.

The base material 1 shown in Fig. 1 has a support layer 1b and a cushion layer 1a. The support layer 1b may be attached to the cushion layer 1a via an adhesive layer not shown.

The thickness of the entire base material 1 is preferably from 50 to 400 $\mu$m, more preferably from 100 to 350 $\mu$m, and even more preferably from 150 to 300 $\mu$m. This thickness is specifically 50, 100, 150, 200, 250, 300, 350 or 400 $\mu$m, for example, and may be in the range between any two of the values exemplified above.

MD and TD of the base material 1 can be adjusted by thermal history of the base material 1 (in particular, the support layer 1b) during its manufacture. The thermal history can be determined by differential scanning calorimetry. The thermal history may be strength of the base material 1 pulled in MD and TD by biaxial stretching during the manufacture of the base material 1. By manufacturing the base material 1 so that the thermal history of MD of base material 1 is the same as that of TD of the base material 1, each thermal shrinkage of the base material 1 in MD and TD after heating at a temperature of 130°C or less for 10 minutes can be 0% or higher. The base material 1 has not undergone any treatment (e.g., annealing) after its manufacture that changes or eliminates the thermal history.

<Cushion Layer 1a>

The cushion layer 1a has a melting point of 70°C or higher, preferably 80°C or higher, and more preferably 85°C or higher. The upper limit of the melting point of the cushion layer 1a of the layers to be laminated is not particularly limited, but is preferably 200°C or less, and more preferably 150°C or less. When the melting point is 70°C or higher, the opposite side laminated with the base material film does not have adhesive properties, and blocking can be reduced when the base material film is rolled up.

The melting point of the cushion layer 1a can be measured in accordance with JIS K7121.

The cushion layer 1a with the melting point of 70° C or higher is provided with the adhesive layer 2 on a part or the entire surface opposite to the side on which the above base material film is laminated. If the adhesive layer 2 is not partially or entirely provided, a portion without the adhesive layer 2 may peel off from the ring frame 3 during heating and attaching with the ring frame 3.

A resin for the cushion layer 1a may contain additives as needed. The cushion layer 1a may be used alone or in combination of two or more types.

The resin for the cushion layer 1a with the melting point of 70°C or higher is not limited, but includes, for example, ionomer resin, ethylene-vinyl acetate copolymer, soft polypropylene resin, ethylene-(meth)acrylic acid copolymer resin, styrene-butadiene copolymer resin, hydrogenated styrene-butadiene copolymer resin, ethylene-1-butene copolymer resin, and soft acrylic resin. The resin may be used alone or in combination with two or more types.

The ionomer resin is not limited as long as a predetermined polymer is intermolecularly bonded with metal ions, but includes, for example, polyolefin ionomers, acrylic ionomers, polystyrene ionomers, and polyester ionomers. These ionomer resins may be used alone or in combination. Among these, polyolefin-based ionomers and acrylic-based ionomers are preferred, and polyolefin-based ionomers are more preferred. The use of such resins tends to improve the tracking and peeling properties.

The polyolef-based ionomers are not limited, but include, for example, ethylene-methacrylate copolymers, ethylene-acrylate copolymers, ethylene- methacrylate-acrylate copolymers, and the like.

The acrylic-based ionomers are not limited, but include, for example, acrylic ester-acrylate copolymers, acrylic ester-methacrylate copolymers, methacrylic ester-acrylate copolymers, methacrylic ester-methacrylate copolymers and the like.

The polystyrene-based ionomers are not limited, but include, for example, styrene-styrenesulfonate copolymers, styrene-acrylate copolymers, styrene-methacrylate copolymers, styrene-styrene carboxylate copolymer, styrene-N-methyl 4-vinylpyridinium salt copolymer and the like.

The polyester-based ionomers are not limited, but include, for examples, sulfoterephthalate copolymerized polyethylene terephthalate, sulfoisophthalate copolymerized polyethylene terephthalate, sulfoterephthalate copolymerized polybutylene terephthalate, sulfoisophthalate copolymerized polybutylene terephthalate and the like.

The metal ions constituting the salts of the above ionomer resins are not limited, but include, for example, monovalent metal ions such as sodium and lithium ions; divalent metal ions such as zinc, calcium, and magnesium ions; trivalent metal ions such as aluminum ions; and the like. The polymer and metal ions in the ionomer resin can be used in any combination based on the ionic functional group in the polymer and the valence of the metal ion.

The ethylene-vinyl acetate copolymer is not limited as long as it is a copolymer of ethylene and vinyl acetate. The content of vinyl acetate in the ethylene-vinyl acetate copolymer is preferably 1 to 35 mol%, more preferably 3 to 25 mol%, and even more preferably 3 to 15 mol%, relative to the total number of moles of the component units derived from ethylene and vinyl acetate. When the content of vinyl acetate is within the above range, the tracking and peeling properties tend to be more improved.

The soft polypropylene resins are not limited, but include, for example, rubber components or polyolefin resins blended with polypropylene resins and propylene-or olefin random copolymers. The rubber components used here are not limited, but include, for example, styrene-butadiene copolymerized rubber, hydrogenated styrene-butadiene copolymerized rubber, styrene-butadiene-styrene block copolymerized rubber, hydrogenated styrene-butadiene-styrene block copolymerized rubber, styrene-isoprene-styrene block copolymerized rubber, ethylene-propylene copolymerized rubber and the liek. The polyolefin resins used here include polyethylene resin, polypropylene resin, and cyclo-olefin polymer resin, preferably, polyethylene resin. The $\alpha$-olefins of copolymerization components used here include ethylene, 1-butene, 1-pentene, 1-hexene, 4-methyl-1-pentene, 1-heptene, 1-octene and the like. Specific examples of propylene-$\alpha$-olefin random copolymers are propylene-ethylene random copolymer, propylene-1-butene random copolymer, and propylene-1-hexene random copolymer, propylene ethylene-1-butene copolymer, and the like, preferably propylene-ethylene random copolymer.

The mass average molecular weight (Mw) of the resin of the cushion layer 1a, which has a melting point of 70°C or higher, is preferably 10,000 to 1,000,000, more preferably 50,000 to 500,000.

The mass average molecular weight (Mw) is a polystyrene equivalent value measured by gel permeation chromatography (GPC) under the measurement conditions described below.

| | |
|---|---|
| Equipment name: | SYSTEM-21 Shodex (manufactured by Showa Denko) |
| Column: | 3 PL gel MIXED-Bs in series |
| Temperature: | 40°C |
| Detection: | Differential refractive index |
| Solvent: | Tetrahydrofuran |
| Concentration: | 2 mass percent |
| Calibration curve: | Standard polystyrene (PS) (manufactured by PL) was used to prepare the calibration curve. |

The thickness of the cushion layer 1a with the melting point of 70°C or higher is preferably 50 to 500 $\mu$m, more preferably 70 to 400 $\mu$m, and even more preferably 100 to 300 $\mu$m. The thickness of the cushion layer 1a with the melting point of 70°C or higher is within the above range to provide sufficient tracking and adhesiveness against unevenness caused by scratches on the surface of the ring frame and unevenness on the surface of the semiconductor wafer.

The cushion layer 1a with the melting point of 70°C or higher can be produced in accordance with well-known techniques. The forming method is not particularly limited, but the above various materials are mixed so that each component is uniformly dispersed using customary melt-kneading and various mixing devices (single- or twinscrew extruders, rolls, Banbury mixers, various kneaders, etc.), the mixture is formed into a film using the T-die method, calendering method, or inflation method, and then laminated with the support layer 1b via an adhesive.

The resin of cushion layer 1a with the melting point of 70°C or higher may contain other additives such as known plasticizers, heat stabilizers, colorants, organic or inorganic lubricants, surfactants, processing aids and the linke, as needed.

<Support Layer 1b>

The support layer 1b is a layer to maintain flatness of the wafer after grinding. Without the support layer, the backside of the base material would be uneven due to the projected portions 5 of the wafer, resulting in poor backside grindability.

As described below, the adhesive sheet 10 can be attached to the semiconductor wafer 4 under normal or reduced pressure. When the adhesive sheet 10 is attached to the semiconductor wafer 4 under the reduced pressure, the support layer 1b have preferably gas barrier properties.

If the support layer 1b has low oxygen permeability, it usually also has low air permeability, so the support layer 1b prevents outside air from entering a sealed space 2b through the base material 1, thereby making it easier for the base material 1 to follow the projected portions 5.

Preferably, the support layer 1b is provided so that the oxygen permeability of the base material 1 measured according to JIS K 7126-2 (isobaric method) at 25°C and under RH 0% is 1000 ml / (m$^2$·24h·atm) or less. Preferably, the oxygen permeability of the support layer 1b alone under the same conditions is 1000 ml / (m$^2$·24h·atm) or less in order to ensure that the oxygen permeability of the base material 1 falls within such a range. In such a case, the above effect is easily exerted. The oxygen permeability of the base material 1 or the support layer 1b is, for example, 0 to 1000 ml / (m$^2$·24h·atm), and preferably 0 to 500 ml / (m$^2$·24h·atm), specifically, may be 0, 100, 200, 300, 400, 500, 600, 700, 800, 900 or 1000 ml / (m$^2$·24h·atm), or may be in the range between any two of the values examplified above.

Preferably, the oxygen permeability of the support layer 1b under the above conditions is lower than that of the cushion layer 1a. Preferably, the value of (oxygen permeability of cushion layer 1a - oxygen permeability of support layer 1b) is 100 ml / (m$^2$·24h·atm) or higher. This value is, for example, 100 to 3000 ml / (m$^2$·24h·atm), specifically may be 100, 500, 1000,1500, 2000, 2500, 3000 ml / (m$^2$·24h·atm), or may be in the range between any two of the values examplified above.

Polyester (e.g., polyethylene terephthalate (PET)), polyimide, and polyamide (e.g., nylon) are preferred for the support layer 1b from the viewpoint of being rigid and resistant to deformation.

The thickness of the support layer 1b is, for example, 5 to 50 $\mu$m, preferably 10 to 30 $\mu$m. If the support layer 1b is too thin, the flatness of the wafer after grinding is low. If the support layer 1b is too thick, the base material 1 may not follow the projected portions 5 of the base material 1. This thickness is specifically 5, 10, 11, 12, 13, 14, 15, 20, 21, 23, 24, 25, 30, 35, 40, 45, or 50 $\mu$m, for example, or may be in the range between any two of the values examplified above.

To maintain the flatness of the wafer after grinding, Young's modulus of the support layer 1b is 500 MPa to 5000 MPa, preferably 1000 MPa to 4500 MPa. The Young's modulus in this embodiment can be measured at a pulling speed of 300 mm/min at a temperature of 23 $\pm$ 2°C and under a humidity of 50 $\pm$ 5%.

<Adhesive Layer 2>

The adhesive layer 2 is a layer for attaching the adhesive sheet 10 to the semiconductor wafer 4, and is formed by an adhesive. The shape of the adhesive layer 2 is not limited as long as it is a shape that enables the adhesive sheet 10 to be attached to the semiconductor wafer 4. The adhesive layer 2 may be configured with an aperture smaller in diameter than the diameter of the semiconductor wafer 4. The aperture is a portion where no adhesive is provided and is smaller in diameter than the diameter of the semiconductor wafer 4. The diameter of the aperture / the diameter of the semiconductor wafer 4 is preferably 0.950 to 0.995, and more preferably 0.960 to 0.990.

When the adhesive layer 2 has the aperture, a peripheral portion 4a of the semiconductor wafer 4 is attached to the adhesive layer 2 so that the projected portions 5 of the semiconductor wafer 4 are placed within the aperture. Therefore, the projected portions 5 do not come into contact with the adhesive, and the adhesive is prevented from remaining on the projected portions 5.

The thickness of the adhesive layer 2 is usually from 1 to 200 $\mu$m, preferably from 2 to 170 $\mu$m, and more preferably from 5 to 150 $\mu$m. If the thickness of the adhesive layer 2 is less than 1 $\mu$m, sufficient adhesive strength to the surface of the ring frame 3 or the surface of the semiconductor wafer 4 cannot be ensured. If the thickness of the adhesive layer 2 is thicker than 200 $\mu$m, the adhesive may remain on the surface of the ring frame 3 or the semiconductor wafer 4 when removing the adhesive sheet 10 from the surface of the ring frame 3 or the surface of the semiconductor wafer 4, which reduces economic efficiency.

The adhesive in the adhesive layer 2 is not particularly limited, but may include, for example, a polymer and a curing agent, and may include other components as needed. The polymer included in the adhesive layer 2 is not particularly limited, but may include, for example, (meth)acrylic ester copolymers having a linear, branched, or cross-linked form. There are two types of branches possessed by the polymer with the branched form: short-chain branches, which are branches with a length of up to several carbons; and long-chain branches, which are branches with a length comparable to that of the main chain. The polymer in the cross-linked form may also have a three-dimensional network structure. The polymer in the cross-linked form also includes those formed by the reaction of the polymer and the curing agent described below.

The constituent units of (meth)acrylic acid ester copolymers include alkyl group-containing constituent units, hydroxyl group-containing constituent units, carboxyl group-containing constituent units, and other constituent units. These constituent units are mainly derived from (meth)acrylic acid monomers or (meth)acrylic ester monomers, but (meth)acrylic ester copolymers are not limited to polymers composed solely of (meth)acrylic acid or its esters, and can also be derived from monomers having polymerizable double bonds other than (meth)acrylic acid, etc.

(Meth)acrylic ester copolymers can be cross-linked with the curing agent described below due to the constituent units having hydroxyl groups and carboxyl groups. Such a crosslinked structure can improve the cohesive strength of the adhesive after adhesive application. Also, by adjusting the degree of cross-linking, the storage modulus and loss modulus, as well as 180°C peel strength and tack to the ring frame and semiconductor wafer can be adjusted.

The constituent units having alkyl groups include monomers that do not have functional groups for crosslinking reactions with the curing agents described below. The monomers constituting the constituent units having such hydrocarbon groups are not limited, but include alkyl (meth)acrylates having linear, branched, or branched alkyl groups such as methyl groups, ethyl groups, n-pulpylic groups, isopulpylic groups, n-butyl groups, t-butyl groups, isobutyl groups, amyl groups, isoamyl groups, hexyl groups, heptyl groups, cyclohexyl groups, 2-ethylhexyl groups, octyl groups, isooctyl groups, nonyl groups, isononyl groups, decyl groups, isodecyl groups, undecyl groups, lauryl groups, tridecyl groups, tetradecyl groups, stearyl groups, octadecyl groups, and dodecyl groups. These may be used alone or in combination with two or more selected monomers.

The monomers constituting the constituent units having hydroxyl groups are not particularly limited, but include hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 1-hydroxydecyl (meth)acrylate, 12-hydroxylauryl (meth)acrylate and (4-hydroxymethyl cyclohexyl) methyl (meth)acrylate. These may be used alone or in combination with two or more selected monomers.

The monomers constituting the constituent units having carboxyl groups are not particularly limited, but include carboxyl group-containing monomers such as acrylic acid, methacrylic acid, carboxyethyl (meth)acrylate, carboxypentyl (meth)acrylate, itaconic acid, maleic acid, fumaric acid, and crotonic acid. These may be used alone or in combination with two or more selected monomers.

The monomers constituting other constituent units other than the above are not particularly limited, but include, for example, acid anhydride monomers such as maleic anhydride and itaconic anhydride; sulfonic acid group-containing monomers such as styrene sulfonic acid, arylsulfonic acid, 2-(meth)acrylamido-2-methylpropanesulfonic acid, (meth)acrylamidopropanesulfonic acid, sulfopropyl (meth)acrylate, and (meth)acryloyloxynaphthalate; and phosphate group-containing monomers such as 2-hydroxyethylacryloylphosphate.

The curing agents constituting the adhesive layer 2 are not particularly limited, but include isocyanate curing agents, epoxy curing agents, and amine curing agents, which may be single substances or mixtures. Among these, isocyanate compounds are preferred.

Such isocyanate compounds are not particularly limited, but include, for example, aromatic isocyanates such as tolylene diisocyanate, 4, 4-diphenylmethane diisocyanate, xylylene diisocyanate, trimethylolpropane modified tolylene diisocyanate; alicyclic diisocyanates such as isophorone diisocyanate and methylenebis(4-cyclohexylisocyanate); aliphatic diisocyanates such as hexamethylene diisocyanate and trimethylhexamethylene diisocyanate. These may be used alone or in combination with two or more selected isocyanate compounds.

In order to improve adhesion between the cushion layer 1a with the melting point of 70°C or higher and the adhesive layer 2, surface treatment may be chemically or physically applied as necessary. The surface treatments include, for example, corona treatment, chromic acid treatment, ozone exposure, flame exposure, high voltage electric shock exposure, and ionizing radiation treatment.

The adhesive layer 4 can be manufactured according to well-known techniques. Although the forming method is not particularly limited, the adhesive layer 2 is formed by dissolving the above various materials in a solvent such as an organic solvent to form a varnish, which is then coated on a protective film by a knife coat method, a roll coat method, a spray coat method, a gravure coat method, a bar coat method, a curtain coat method, a screen printing method or the like, and then removing the solvent.

<Semiconductor Wafer 4>

The semiconductor wafer 4 has the projected portions 5. Each of the projected portions 5 has any structure that protrudes in the out-of-plane direction of the semiconductor wafer 4. The projected portions 5 include, for example, protruding electrodes and projected portions of a circuit having concavoconvexities and convexities.

The semiconductor wafer 4 includes not only a silicon wafer, but also a germanium wafer, a gallium-arsenide wafer, a gallium-phosphorus wafer, a gallium-arsenide- aluminum wafer, a sapphire wafer, a glass wafer, a silicon carbide wafe. The diameter of the semiconductor wafer 4 is preferably from 1 to 16 inches, more preferably 4 to 12 inches. The thickness of the semiconductor wafer 4 is not particularly limited, but preferably 500 to 800 $\mu$m, more preferably 520 to 775 $\mu$m.

The height of each of the projected portions 5 is preferably between 10 and 500 $\mu$m, more preferably between 100 and 300 $\mu$m. This height may specifically be, for example, 10, 50, 100, 150, 200, 250, 300, 350, 400, 450, or 500 $\mu$m, and may be in the range between any two of the values examplified above.

The semiconductor wafer 4 may have the peripheral portion 4a without the projected portions 5. The width of the peripheral portion 4a is preferably 1.0 to 3.0 mm, more preferably 1.5 to 2.5 mm.

End products using the semiconductor wafer 4 having the projected portions 5 include electronic components for logic, memory, sensors, power supplies, and other applications.

2. Method for Manufacturing Semiconductor Devices

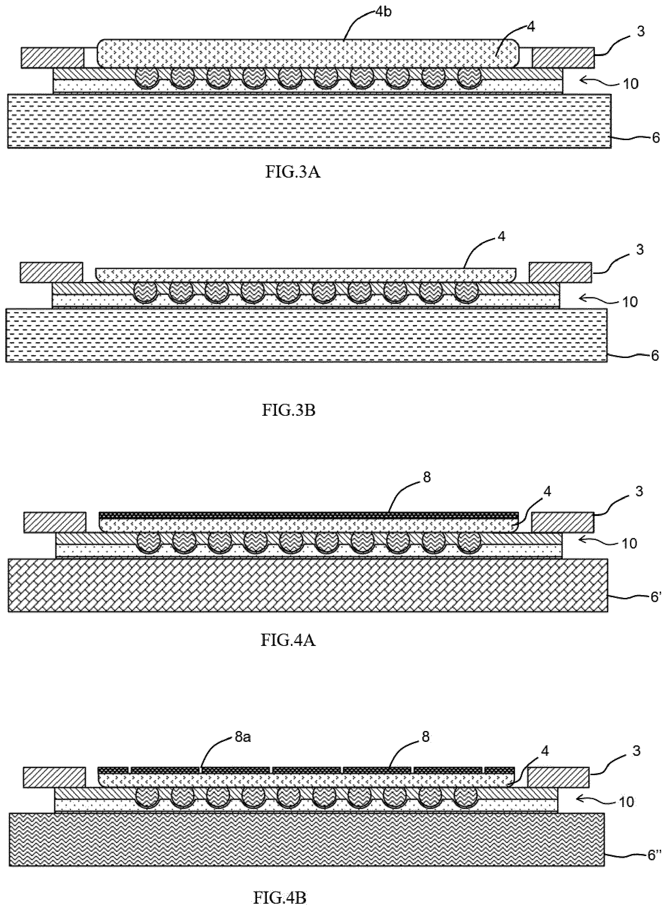

Based on Figs. 1 to 4E, a method for manufacturing semiconductor devices using the adhesive sheet 10 is described. This manufacturing method has a frame attaching step, a heating step, a grinding step, and a dicing step. The order in which these steps are carried out is not limited to this order, and the order can be interchanged as necessary. Each step is described below.

<Frame Attaching Step>

As shown in Figs. 2a and 2b, in the frame attaching step, the adhesive sheet 10 is attached to the ring frame 3. The ring frame 3 has an aperture 3a. The diameter of the aperture 3a is smaller than that of the adhesive layer 2. This allows the adhesive sheet 10 to be held stably in the ring frame 3, facilitating handling of the adhesive sheet 10.

<Wafer Attaching Step and Heating Step>

As shown in Figs. 2B and 2C, in a wafer attaching step, the adhesive sheet 10 is attached to the surface of the semiconductor wafer 4 having the projected portions 5 under normal or reduced pressure.

This step can be performed by attaching the semiconductor wafer 4 to the adhesive sheet 10 in a vacuum chamber 16. The pressure in the vacuum chamber 16 need only be lower than atmospheric pressure, preferably at 1000 Pa or lower, more preferably at 500 Pa or lower, even more preferably at 100 Pa or lower. The lower limit of the pressure in the vacuum chamber 16 is not specified, but is, for example, 10 Pa.

By attaching the semiconductor wafer 4 to the adhesive sheet 10 under the reduced pressure in this manner, the inside of the sealed space 2b surrounded by the semiconductor wafer 4 and the adhesive sheet 10 is under the reduced pressure.

In this state, when the adhesive sheet 10 with the semiconductor wafer 4 attached is removed from the vacuum chamber 16 and then exposed to atmospheric pressure, the base material 1 is pushed by the atmospheric pressure and enters the sealed space 2b. The base material 1 is rigid when not heated, and the base material 1 hardly enters the sealed space 2b. On the other hand, when the base material 1 is heated to 60 to 150°C in the heating step, the base material 1 is softened and the sealed space 2b disappears or almost disappears, as shown in Fig. 2D. As a result, the projected portions 5 becomes embedded in the base material 1, and the projected portions 5 are protected by the base material 1. The ratio of the height of the embedded portion of the projected portion 5 / the height of the entire projected portion 5 is preferably 0.9 to 1, more preferably 0. 95 to 1, even preferably 0. 99 to 1. The heating temperature of the base material 1 is preferably 80 to 120°C. The heating time of the base material 1 is preferably from 3 to 120 seconds, and more preferably from 5 to 60 seconds.

The heating of the base material 1 may be performed before or after attaching the semiconductor wafer 4 to the adhesive sheet 10. The heating may be performed in the vaccume chamber 16 or outside the vaccume chamber 16.

<Grinding Step>

As shown in Figs. 3A and 3B, in the grinding step, the back surface 4b of the semiconductor wafer 4 is ground. The semiconductor wafer 4 is fixed to a suction table 6 via the adhesive sheet 10.

The back surface 4b of the semiconductor wafer 4 is the opposite side of the surface on which the projected portions 5 are provided. There is no limitation on the step for grinding the back surface of the wafer, and any known grinding method can be used. The grinding is preferably performed while water is applied to the wafer and grinding wheel (e.g., diamond) to cool them. The thickness of the thinner wafer is preferably 300 $\mu$m or less, more preferably 150 $\mu$m or less.

During back grinding, a load in the in-plane direction of the semiconductor wafer 4 is applied to the projected portions 5, so the projected portions 5 are easily damaged. However, in this embodiment, at least part of each of the projected portions 5 is embedded in the base material 1, so the projected portions 5 are supported stably by the base material 1, making the projected portions 5 less likely to be damaged. If the support of the projected portions 5 by the base material 1 is unstable, the grindability may decrease.

A curable resin may be used to prevent damage to the projected portions 5. The curable resin is a resin that hardens upon stimulation by energy rays (e.g., ultraviolet rays) or heat. The curable resin is preferably supported on a support film and placed between the support film and the support layer 1b of the adhesive sheet 10.

The curable resin has preferably a viscosity of 100 to 3000 mPa·s, more preferably a viscosity of 100 to 3000 mPa·s before curing. When the viscosity is 100 mPa·s or higher, the curable resin makes point contact instead of surface contact, resulting in excellent grindability. When the viscosity is 3000 mPa·s or less, the curable resin does not easily entrap air bubbles when it flows between adjacent projected portions 5, resulting in excellent grindability. The viscosity is measured using an E-type viscometer at 23°C and 50 rpm.

The curable resin has preferably Shore D hardness of 5 to 70, more preferably Shore D hardness of 10 to 60 after curing. When the Shore D hardness is 5 or higher, the projected portions 5 are retained well, resulting in excellent grindability. When the Shore D hardness is 70 or less, the adhesive sheet 10 can be easily curved when peeling the adhesive sheet 10 from the semiconductor wafer 4. The Shore D hardness is measured under conditions in accordance with JIS K 6253.

The curable resin is preferably photo-curable resin, more preferably UV-curable resin.

The curable resin is preferably based on acrylic resins, and their composition is not particularly limited, but the curable resin containing 1,2-hydrogenated polybutadiene-terminated urethane (meth)acrylate, isobornyl acrylate, or diethylacrylamide is preferred because it can improve the adhesion between the base material 1 and the support film 7.

The cure shrinkage of the curable resin is preferably 7% or less.

If the height of each of the projected portions 5 is Td ($\mu$m), the thickness of the curable resin is preferably (Td + 20) to (Td + 200) $\mu$m, more preferably (Td + 50) to (Td + 150) $\mu$m.

The support film is any film that can support the curable resin and can be made of polyolefins such as ethylene vinyl acetate, polyethylene, polypropylene, polybutene and polybutadiene; polyvinyl chloride; polyethylene terephthalate; polyethylene naphthalate; polystyrene; polycarbonate; polyimide; and the like.

The thickness of the support film is preferably 10 to 300 $\mu$m, more preferagly 30 to 250 $\mu$m.

<Dicing Step>

As shown in Figs. 4A to 4E, in the dicing step, the semiconductor wafer is divided into individual pieces. In the dicing step, the semiconductor wafer 4 is divided into multiple semiconductor chips by dicing on the ground semiconductor wafer 4. The dicing method is not limited and may be any method such as blade dicing, laser dicing, stealth dicing, plasma dicing, and the like.

The dicing step may have a coating step in which a mask 8 capable of forming a pattern (groove) for the dicing by a patterning means (e.g., laser) is coated on the ground back surface 4b (Fig. 4A). The pattern for the dicing indicates the position where the dicing is to be performed. The mask 8 may be, for example, a (meth)acrylic copolymer. In the coating step, the ground semiconductor wafer 4 is fixed to a suction table 6' via the adhesive sheet 10.

The dicing step may also include a pattern forming step in which a pattern 8a for the dicing is formed on the mask 8 by pattern forming means after the coating step (Fig. 4B ). By performing the dicing along the pattern 8a, the semiconductor wafer 4 can be easily divided into semiconductor chips having the desired size. In the pattern forming step, the ground semiconductor wafer 4 is fixed to a suction table 6" via the adhesive sheet 10.

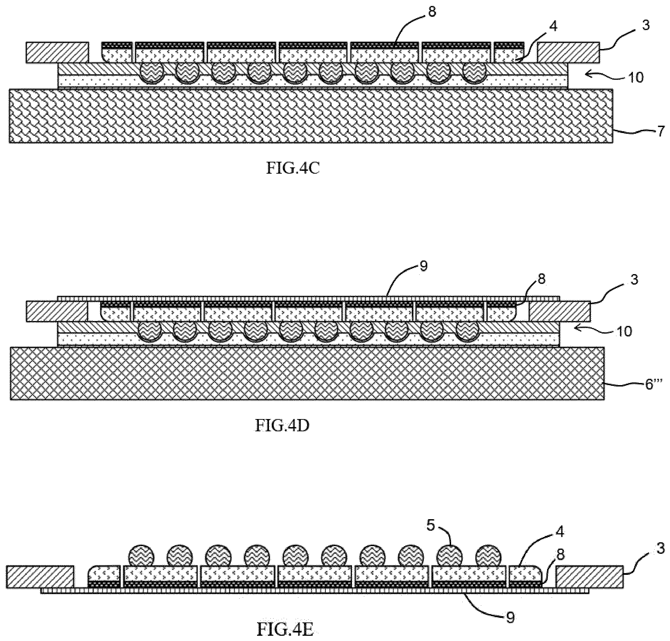

Fig. 4C shows the dicing step in which the dicing is performed along the pattern 8a. The dicing step may further include a fixing step in which the semiconductor wafer 4 is fixed to a fixing table 7 (e.g., electrostatic table or suction table) via the adhesive sheet 10 before the dicing.

When the dicing step is performed, a plurality of semiconductor chips is adhered to the adhesive sheet 10. Therefore, the dicing step may have a dicing tape attaching step in which a dicing tape 9 is attached to the back surface 4b of the diced semiconductor wafer 4 (Fig. 4D). The dicing tape 9 may be attached to the back surface 4b of the semiconductor wafer 4 or may be attached to the back surface 4b of the semiconductor wafer 4 and the ring frame 3. This prevents one or more semiconductor chips from remaining attached to the adhesive sheet 10 during the peeling step (Fig. 4E) in which the adhesive sheet 10 is removed from the semiconductor wafer 4. The dicing tape 9 may be, for example, a UV curable dicing tape or a general pressure-sensitive dicing tape with low adhesive strength, and a substrate of the dicing tape may be polyolefin such as polyvinyl chloride, polyethylene and polypropylene. In the dicing tape attaching step, the semiconductor wafer 4 is fixed to the fixing table 6 (e.g., electrostatic table or suction table) via the adhesive sheet 10.

[EXAMPLES]

The invention is described in more detail below based on examples, but the invention is not limited to these examples.

(Example 1)

The base material film was formed by dry lamination of polyethylene terephthalate film having a thickness of 25 μm (Toray, product number: Lumirror S10) and an ionomer film (melting point 82°C) having a thickness of 150 μm formed by the T-die method.

(Example 2)

The base material film was formed in the same way as in Example 1, except that the polyethylene terephthalate film was replaced with nylon film having a thickness of 15 μm (Toyobo, product number: N1202).

(Example 3)

The base material film was formed in the same way as in Example 1, except that the polyethylene terephthalate film was replaced with polyimide film having a thickness of 12 μm (SKC KOLON PI, product number: GF050).

(Comparative Example 1)

The base material film was formed in the same way as in Example 1, except that the polyethylene terephthalate film was replaced with a 12 iim thick polyethylene terephthalate film having a thickness of 12 μm (SHINKONG MATERIALS TECHNOLOGY, product number: P121).

(Comparative Example 2)

The base material film was formed in the same way as in Comparative Example 1, except that the polyethylene terephthalate film of Comparative Example 1 was annealed (at 200°C for 5 min).

(Comparison Example 3)

The base material film was formed in the same way as in Example 1, except that the polyethylene terephthalate film of Example 1 was annealed (at 200°C for 5 min).
The details of the evaluation method are as follows. The evaluation results are shown in Table 1.

<Sagging of Base Material Layer>

A silicon wafer is placed on a stage with the same diameter as that of the silicon wafer. The silicon wafer is heated at 130°C for 10 minutes with the base material layer bonded to the ring frame pressed on top of the silicon wafer. The entire silicon wafer is removed from the stage. After that, the base material layer is checked for sagging between the inner edge of the ring frame and the edge of the silicon wafer after 30 minutes of standing still under an atmosphere of 23°C.

    A (Superior): No sagging
    B (not available):Occurrence of Sagging

<Wrinkles in Base Material Layer on Surface of Silicon Wafer>
A silicon wafer is placed on a stage with the same diameter as that of the silicon wafer. The silicon wafer is heated at 130°C for 10 minutes with the base material layer attached to the ring frame pressed on top of the silicon wafer. The entire silicon wafer is removed from the stage. After that, the silicon wafer is placed under an atmosphere of 23°C for 30 minutes, and then the silicon wafer is checked for wrinkles on the surface where the base material layer is attached to the silicon wafer.

        A (Superior):         No wrinkles

(continued)

B (not acceptable):     Occurrence of Wrinkles

[Table 1]

| Table 1 | Example | | | Comparative Example | | |
|---|---|---|---|---|---|---|
| | 1 | 2 | 3 | 1 | 2 | 3 |
| Material | PET | Nylon 6 | Polyimide | PET | Annealed PET | Annealed PET |
| Thickness (μm) | 25 | 15 | 12 | 12 | 12 | 25 |
| MD Thermal Shrinkage (%) | 0.3 | 0.75 | 0.00 | 0.49 | 0.17 | 0.12 |
| TD Thermal Shrinkage (%) | 0.14 | 0.25 | 0.00 | -0.13 | -0.06 | -0.04 |
| MD/TD | 2.14 | 3. 00 | 0.00 | -3.77 | -2.83 | -3.00 |
| Sagging of Base Material Film | A | A | A | B | B | B |
| Wrinkles of Silicon Wafer Surface | A | A | A | B | B | B |

<Consideration>

All examples showed excellent results in all evaluation items. On the other hand, all comparative examples did not achieve satisfactory results in at least one of the evaluation items.

[DESCRIPTION OF THE REFERENCE NUMERAL]

1:              Base material
1a:             Cushion layer
1b:             Support layer
2:              Adhesive layer
2b:             Sealed space
3:              Ring frame
3a:             Aperture
4:              Semiconductor wafer
4a:             Peripheral portion
4b:             Back side
5:              Projected portion
6, 6', 6", 6''':    Suction table
7:              Dicing table
8:              Mask
9:              Dicing tape
10:             Adhesive sheet
16:             Vacuum chamber

## Claims

1.  A base material used for adhesive sheets for processing a semiconductor wafer having projected portions, wherein each thermal shrinkage of the base material in machine direction (MD) and transverse direction (TD) after heating at 130°C for 10 minutes is 0% or higher.

2.  The base material according to claim 1, wherein a ratio of the thermal shrinkages of the base material in MD and TD (MD/TD) after heating at 130°C for 10 minutes is 3.5 or less.

3. The base material according to claim 1 or 2, wherein each thermal shrinkage of the base material in MD and TD after heating at 130°C for 10 minutes is 1.0% or less.

4. The base material according to any one of claims 1 to 3, wherein the base material has a support layer and a cushion layer, and the cushion layer has a melting point of 70°C or higher.

5. An adhesive sheet for processing a semiconductor wafer having projected portions, the adhesive sheet comprising the base material according to claim 4 and an adhesive layer provided on the base material,
   wherein the adhesive sheet is configured so that the projected portions are protected by the base material when the semiconductor wafer is attached to the adhesive layer.

6. The adhesive sheet according to claim 5, wherein the support layer is provided on the opposite side of the adhesive layer as viewed from the cushion layer.

7. The adhesive sheet according to claim 5 or claim 6, wherein the projected portions are protected by being embedded in the base material.

8. The adhesive sheet according to any one of claims 5 to 7, wherein the semiconductor wafer is attached to the adhesive layer.

9. A method for manufacturing semiconductor devices using the adhesive sheet according to any one of claims 5 to 8,

   wherein the method comprises a frame attaching step, a wafer attaching step, a heating step, a grinding step, and a dicing step,
   in the frame attaching step, the adhesive sheet is attached to a ring frame,
   in the wafer attaching step, the adhesive sheet is attached to a surface with the projected portions of the semiconductor wafer,
   in the heating step, the base material is heated,
   in the grinding step, a back surface of the semiconductor wafer is ground, and
   in the dicing step, the semiconductor wafer is diced into individual pieces.

10. The method for manufacturing the semiconductor devices according to claim 9, wherein the dicing step further comprises a fixing step, and
    in the fixing step, the semiconductor wafer is fixed to a table via the adhesive sheet.

FIG.1

FIG.2A

FIG.2B

FIG.2C

FIG.2D

FIG.3A

FIG.3B

FIG.4A

FIG.4B

FIG.4C

FIG.4D

FIG.4E

## INTERNATIONAL SEARCH REPORT

| International application No. |
| --- |
| **PCT/JP2022/037680** |

| A. | CLASSIFICATION OF SUBJECT MATTER |
| --- | --- |

*H01L 21/304*(2006.01)i; *B32B 27/00*(2006.01)i; *C09J 7/20*(2018.01)i; *C09J 7/29*(2018.01)i; *C09J 7/38*(2018.01)i; *C09J 201/00*(2006.01)i; *H01L 21/301*(2006.01)i; *H01L 21/683*(2006.01)i
FI: H01L21/304 622J; H01L21/304 631; H01L21/68 N; C09J7/20; C09J7/29; B32B27/00 M; C09J7/38; C09J201/00; H01L21/78 M

According to International Patent Classification (IPC) or to both national classification and IPC

| B. | FIELDS SEARCHED |
| --- | --- |

Minimum documentation searched (classification system followed by classification symbols)

H01L21/304; B32B27/00; C09J7/20; C09J7/29; C09J7/38; C09J201/00; H01L21/301; H01L21/683

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2003-138228 A (NITTO DENKO CORP.) 14 May 2003 (2003-05-14) paragraphs [0001], [0004]-[0010], [0034]-[0050] | 1-10 |
| Y | JP 2011-054940 A (NITTO DENKO CORP.) 17 March 2011 (2011-03-17) paragraphs [0002], [0003] | 1-10 |
| Y | WO 2013/084952 A1 (LINTEC CORP.) 13 June 2013 (2013-06-13) paragraphs [0107]-[0111] | 1-10 |
| Y | WO 2018/181240 A1 (FURUKAWA ELECTRIC CO., LTD.) 04 October 2018 (2018-10-04) paragraphs [0081], [0082], [0122], [0123] | 4-10 |
| Y | JP 2011-018669 A (NITTO DENKO CORP.) 27 January 2011 (2011-01-27) paragraphs [0054], [0055], [0062] | 4-10 |
| Y | JP 2000-216123 A (OKAMOTO MACHINE TOOL WORKS LTD.) 04 August 2000 (2000-08-04) paragraphs [0028], [0029] | 9-10 |

☑ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **28 October 2022** | **08 November 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
| --- |
| **PCT/JP2022/037680** |

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2013-023665 A (LINTEC CORP.) 04 February 2013 (2013-02-04)<br>  paragraph [0064] | 9-10 |
| A | WO 2020/071159 A1 (MITSUI CHEMICALS TOHCELLO, INC.) 09 April 2020<br>(2020-04-09)<br>  paragraphs [0013], [0014], [0073], [0105] | 1-10 |
| A | WO 2019/208378 A1 (MITSUI CHEMICALS TOHCELLO, INC.) 31 October 2019<br>(2019-10-31)<br>  paragraphs [0016], [0024] | 1-10 |
| A | JP 2013-120841 A (LINTEC CORP.) 17 June 2013 (2013-06-17)<br>  paragraphs [0022], [0122] | 1-10 |

Form PCT/ISA/210 (second sheet) (January 2015)

## INTERNATIONAL SEARCH REPORT
### Information on patent family members

| International application No. |
|---|
| **PCT/JP2022/037680** |

| Patent document cited in search report | | | Publication date (day/month/year) | Patent family member(s) | | Publication date (day/month/year) |
|---|---|---|---|---|---|---|
| JP | 2003-138228 | A | 14 May 2003 | (Family: none) | | |
| JP | 2011-054940 | A | 17 March 2011 | US 2011/0030882 A1 paragraphs [0004]-[0007] CN 101993667 A TW 201117279 A | | |
| WO | 2013/084952 | A1 | 13 June 2013 | US 2014/0342531 A1 paragraphs [0127]-[0131] CN 103975421 A KR 10-2014-0100510 A | | |
| WO | 2018/181240 | A1 | 04 October 2018 | KR 10-2018-0132813 A CN 109075055 A TW 201838082 A | | |
| JP | 2011-018669 | A | 27 January 2011 | US 2011/0008949 A1 paragraphs [0101], [0102], [0120]-[0123] CN 101942278 A TW 201123285 A | | |
| JP | 2000-216123 | A | 04 August 2000 | (Family: none) | | |
| JP | 2013-023665 | A | 04 February 2013 | US 2013/0029137 A1 paragraph [0067] KR 10-2013-0012575 A | | |
| WO | 2020/071159 | A1 | 09 April 2020 | EP 3862403 A1 paragraphs [0014]-[0018], [0132], [0188] CN 112789337 A KR 10-2021-0060491 A TW 202035613 A | | |
| WO | 2019/208378 | A1 | 31 October 2019 | EP 3786246 A1 paragraphs [0017], [0018], [0035], [0036] KR 10-2020-0130424 A CN 112004899 A TW 201945493 A | | |
| JP | 2013-120841 | A | 17 June 2013 | (Family: none) | | |

Form PCT/ISA/210 (patent family annex) (January 2015)

**EP 4 407 659 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020155688 A